# EUROPÄISCHE PATENTSCHRIFT

(11) **EP 3 762 964 B1**
(45) Veröffentlichungstag und Bekanntmachung des Hinweises auf die Patenterteilung: **08.03.2023**
(21) Anmeldenummer: 19701187.7
(22) Anmeldetag: 17.01.2019
(51) Int. Cl.: H01L 23/44, H01L 23/473

(54) **KÜHLEINRICHTUNG ZUR KÜHLUNG EINES LEISTUNGSBAUELEMENTS**
COOLING DEVICE FOR COOLING A POWER COMPONENT
DISPOSITIF DE REFROIDISSEMENT POUR REFROIDIR UN COMPOSANT DE PUISSANCE

(30) Priorität: 07.03.2018 DE 102018203362
(43) Veröffentlichungstag der Anmeldung: 13.01.2021
(73) Patentinhaber: Robert Bosch GmbH, 70442 Stuttgart (DE)
(72) Erfinder: LEHR, Alexandre, 71034 Boeblingen (DE); KIENLE, Wolfram, 71106 Magstadt (DE)
(86) Internationale Anmeldenummer: PCT/EP2019/051131
(87) Internationale Veröffentlichungsnummer: WO 2019/170307

(56) Entgegenhaltungen:
- EP-A2- 2 597 676
- CN-U- 204 929 511
- DE-A1-102014 013 958
- US-A1- 2008 224 303
- US-A1- 2017 040 241
- US-A1- 2017 071 075
- US-B1- 7 990 711

## Beschreibung

### Stand der Technik

Die vorliegende Erfindung betrifft eine Kühleinrichtung zur Kühlung eines Leistungsbauelements sowie eine Elektronikanordnung mit einer derartigen Kühleinrichtung und einem Leistungsbauelement und ein Steuergerät eines Fahrzeugs.

Bei Steuergeräten, insbesondere für Fahrzeuge, besteht eine große Herausforderung darin, dass man Leistungsbauelemente, wie z.B. Kondensatoren, Drosseln, Leistungsschalter oder dgl., räumlich so anordnen muss, dass sie entsprechend einem Schaltplan elektrisch verbunden werden können und gleichzeitig fertigbar, bauraumgerecht und elektrisch sinnvoll sind. Hierbei ergeben sich zusätzlich elektrische und thermische Anforderungen hinsichtlich Induktivitätsproblemen und Wärmeproblemen. Dabei sind in Steuergeräten beispielsweise auch Kondensatoren verbaut, um schnellstmöglich einen kurzfristigen Strombedarf zu decken. Hierdurch können sich jedoch zusätzliche Wärmeprobleme im Steuergerät ergeben.

EP 2 597 676 A2 zeigt ein Leistungsmodulpaket, umfassend eine erste Wärmeableitungsplatte, die einen ersten Strömungspfad, einen zweiten Strömungspfad und einen dritten Strömungspfad umfasst, die nacheinander ausgebildet werden, wobei der erste Strömungspfad und der dritte Strömungspfad so ausgebildet sind, dass sie eine Stufe dazwischen aufweisen und eine zweite Wärmeableitungsplatte, die unter der ersten Wärmeableitungsplatte ausgebildet ist, eine Seite und eine andere Seite aufweist, in deren einer Seite eine Halbleiterbauelement-Montagenut ausgebildet ist und die einen vierten Strömungsweg aufweist, dessen eines Ende mit dem zweiten Strömungsweg verbunden ist und das andere Ende mit dem dritten Strömungsweg verbunden ist, wobei ein durch den ersten Strömungsweg eingeführtes Kühlmaterial basierend auf dem zweiten Strömungsweg auf den dritten Strömungsweg und den vierten Strömungsweg verteilt wird.

US 2017/071075 A1 zeigt eine Halbleiterspeichervorrichtung umfassend ein Substrat mit einer Verdrahtung, einen ersten Halbleiterspeicher, einen Anschlussabschnitt, einen Halter, der den Anschlussabschnitt umgibt, ein Gehäuse und ein erstes plattenförmiges Element. Das Gehäuse beherbergt einen Teil des Halters, des Substrats und des ersten Halbleiterspeichers. Zwischen der ersten Hauptfläche und einem der ersten Hauptfläche zugewandten ersten Wandabschnitt des Gehäuses ist das erste plattenförmige Element angeordnet. Das erste plattenförmige Element ist an einer Seite des zweiten Endabschnitts des Substrats mit dem Halter und der ersten Hauptoberfläche verbunden und weist eine Wärmeleitfähigkeit auf.

### Offenbarung der Erfindung

Die erfindungsgemäße Kühleinrichtung zur Kühlung eines Leistungsbauelements mit den Merkmalen des Anspruchs 1 weist demgegenüber den Vorteil auf, dass eine signifikant verbesserte Kühlleistung erreicht werden kann, so dass das Leistungsbauelement insbesondere auch problemlos in einem Steuergerät eines Fahrzeugs verbaut werden kann. Dabei kann ein besonders kompakter und einfacher Aufbau realisiert werden und ferner auch eine sehr gute elektrische Anbindung des Leistungsbauelements ermöglicht werden. Dies wird erfindungsgemäß dadurch erreicht, dass die Kühleinrichtung ein Kühlgehäuse mit einem Boden und vier Gehäuseflächen aufweist. Das Kühlgehäuse definiert einen zentralen Bauelement-Aufnahmeraum, zur Aufnahme des Leistungsbauelements. Am Kühlgehäuse ist ein Zulauf zum Zuführen eines Kühlmediums und ein Ablauf zum Abführen des erwärmten Kühlmediums vorgesehen. Ferner ist ein erster, zweiter, dritter und vierter Kühlkanal vorgesehen, wobei der erste und zweite Kühlkanal an ersten und zweiten Stirnseiten des Kühlgehäuses ausgebildet ist. Der dritte und vierte Kanal ist an ersten und zweiten Seitenflächen des Kühlgehäuses ausgebildet. Ferner stehen der erste und zweite Kühlkanal mit dem dritten und vierten Kühlkanal in Fluidverbindung. Eine erste und zweite Kühlplatte, welche an der ersten und zweiten Seitenfläche angeordnet ist, begrenzt den dritten und vierten Kühlkanal insbesondere zur Außenseite des Kühlgehäuses. Ferner ist eine dritte und vierte Kühlplatte vorgesehen, welche den ersten und zweiten Kühlkanal an den beiden Stirnseiten begrenzt. Ein Deckel verschließt das Kühlgehäuse. Somit ist eine doppelwandige Kühleinrichtung mit Boden und Deckel vorgesehen, welche einen zentralen Aufnahmeraum für das Leistungsbauelement aufweist. Hierbei sind der Boden und die vier Gehäuseflächen als einteiliges Bauteil vorgesehen und bevorzugt aus einem metallischen Material mit hoher Wärmeleitfähigkeit, insbesondere Aluminium, hergestellt. Durch das Vorsehen der separaten Kühlplatten an den beiden Seitenflächen können ferner individuelle Ausgestaltungen der Kühleinrichtungen auf einfache und kostengünstige Weise realisiert werden. Somit kann z.B. je nach Wahl der Kühlplatten an den Seitenflächen eine Wärmeleitfähigkeit an das jeweilige Leistungsbauelement, welches in der Kühleinrichtung angeordnet ist, angepasst werden.

Die Unteransprüche zeigen bevorzugte Weiterbildungen der Erfindung.

Weiter bevorzugt sind eine dritte und vierte Kühlplatte, welche den ersten und zweiten Kühlkanal an den Stirnseiten begrenzen, ebenfalls einstückig mit dem Kühlgehäuse ausgebildet. Besonders bevorzugt ist hierbei der Boden des Kühlgehäuses an den Stirnseiten verlängert und an diesen Überständen sind dann die dritte und vierte Kühlplatte angeordnet.

Weiter bevorzugt sind direkt an der dritten und vierten Kühlplatte auch der Zulauf und/oder der Ablauf angeordnet. Hierdurch kann eine weitere Kosteneinsparung erreicht werden.

Gemäß einer weiteren bevorzugten Ausgestaltung der Erfindung umfasst die Kühleinrichtung ferner einen fünften Kühlkanal, welcher am Boden des Kühlgehäuses ausgebildet ist und mittels einer dritten Kühlplatte begrenzt ist. Somit können fünf Seiten des Leistungsbauelements gekühlt werden. Der fünfte Kühlkanal steht vorzugsweise mit dem ersten und/oder zweiten Kühlkanal in Fluidverbindung. Alternativ steht der fünfte Kühlkanal mit dem dritten und/oder vierten Kühlkanal in Fluidverbindung.

Weiter bevorzugt ist der Deckel der Kühleinrichtung aus einem elektrisch isolierenden Material, insbesondere einem elektrisch isolierenden Kunststoff. Das Kühlgehäuse ist vorzugsweise aus Metall, insbesondere Aluminium, und die separaten Seitenflächen sind vorzugsweise aus Kupfer oder aus Aluminium.

Gemäß einer weiteren bevorzugten Ausgestaltung der Erfindung sind der Zulauf und der Ablauf an der ersten Stirnseite des Kühlgehäuses gemeinsam angeordnet. Hierdurch kann insbesondere eine Zuleitung und Ableitung zur Kühleinrichtung vereinfacht werden. Vorzugsweise weist dabei die erste Stirnseite einen Fluidteiler, insbesondere eine Trennwand, auf, um den Zulauf vom Ablauf zu trennen.

Alternativ sind der Zulauf und der Ablauf an einander gegenüber liegenden Stirnseiten der Kühleinrichtung angeordnet. Hierdurch weist die Kühleinrichtung nur eine Durchströmungsrichtung durch die Kühlkanäle auf.

Weiter bevorzugt sind an den seitlichen ersten und zweiten Kühlplatten in die Kühlkanäle vorstehende Elemente, wie beispielsweise Kühlrippen, Kühlzylinder oder dgl., vorgesehen. Hierdurch wird eine turbulente Strömung im Kühlkanal erzeugt, wodurch die Wärmeabfuhr verbessert werden kann.

Ferner betrifft die vorliegende Erfindung eine Elektronikanordnung mit einer erfindungsgemäßen Kühleinrichtung und einen im Kühlgehäuse angeordneten Leistungsbauelement. Das Leistungsbauelement ist im Kühlgehäuse vorzugsweise mittels eines Vergusses vergossen. Hierdurch kann durch den Verguss eine elektrische Isolierung des Leistungsbauelements zum Kühlgehäuse ermöglicht werden, wenn der Verguss aus einem elektrisch nicht leitenden Material bereitgestellt wird. Das Leistungsbauelement ist vorzugsweise ein Kondensator, insbesondere ein Zwischenkreiskondensator.

Weiter bevorzugt umfasst die Elektronikanordnung einen ersten und zweiten Leitungsschalter, welche an der ersten und zweiten Kühlplatte der Kühleinrichtung angeordnet sind. Dabei sind besonders bevorzugt der erste und zweite Leitungsschalter symmetrisch zu einer Längsebene der Elektronikanordnung angeordnet. Hierdurch können gleiche elektrische Leitungslängen von den Leitungsschaltern zum im Kühlgehäuse angeordneten Leistungsbauelement sichergestellt werden.

Weiter bevorzugt umfasst die Elektronikanordnung einen elektrischen Anschluss, welcher im Deckel der Kühleinrichtung angeordnet ist. Der elektrische Anschluss erfolgt vorzugsweise an eine Busbar. Weiter bevorzugt erfolgt eine elektrische Kontaktierung zu den Leistungsschaltern mittels einer Bondverbindung.

Ferner betrifft die vorliegende Erfindung ein Steuergerät eines Fahrzeugs mit einer erfindungsgemäßen Elektronikanordnung. Das Steuergerät dient vorzugsweise zur Ansteuerung einer elektrischen Maschine des Fahrzeugs und umfasst einen Zwischenkreiskondensator. Hierdurch kann eine schnelle Ansteuerung der elektrischen Maschine mit kurzen Leitungswegen und niedriger elektrischer Induktivität sichergestellt werden.

### Zeichnung

Nachfolgend werden bevorzugte Ausführungsbeispiele der Erfindung unter Bezugnahme auf die begleitende Zeichnung im Detail beschrieben. In der Zeichnung ist:
- Figur 1: eine schematische, perspektivische Ansicht eines Kühlgehäuses einer Kühleinrichtung gemäß einem ersten Ausführungsbeispiel der Erfindung,
- Figur 2: eine schematische Schnittansicht der Kühleinrichtung des ersten Ausführungsbeispiels,
- Figur 3: eine perspektivische, geschnittene Ansicht des Kühlgehäuses von Figur 1,
- Figur 4: eine Teil-Schnittansicht der Kühleinrichtung von Figur 2,
- Figur 5: eine perspektivische, geschnittene Ansicht einer Kühleinrichtung gemäß einem zweiten Ausführungsbeispiel, und
- Figur 6: eine Schnittansicht einer Kühleinrichtung des zweiten Ausführungsbeispiels.

### Bevorzugte Ausführungsformen der Erfindung

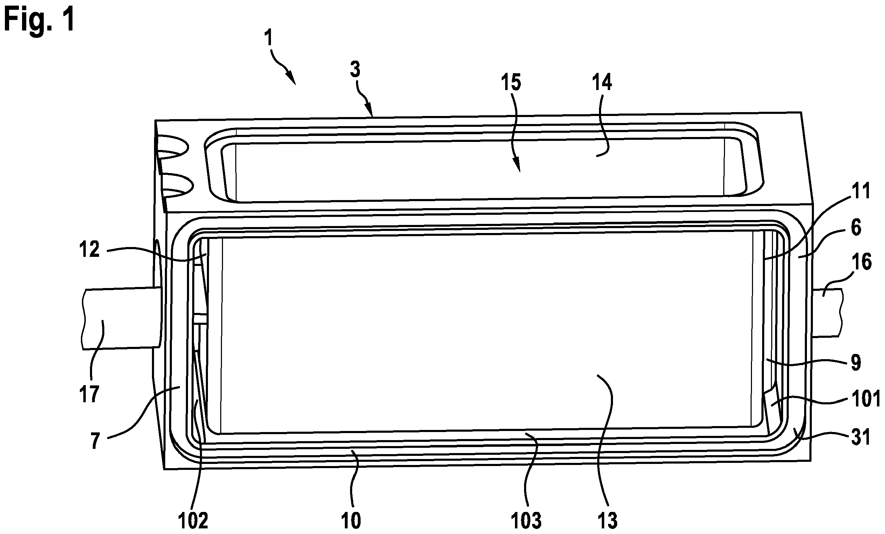

Nachfolgend wird unter Bezugnahme auf die Figuren 1 bis 4 eine Elektronikanordnung 100 mit einer Kühleinrichtung 1 gemäß einem ersten bevorzugten Ausführungsbeispiel der Erfindung im Detail beschrieben.

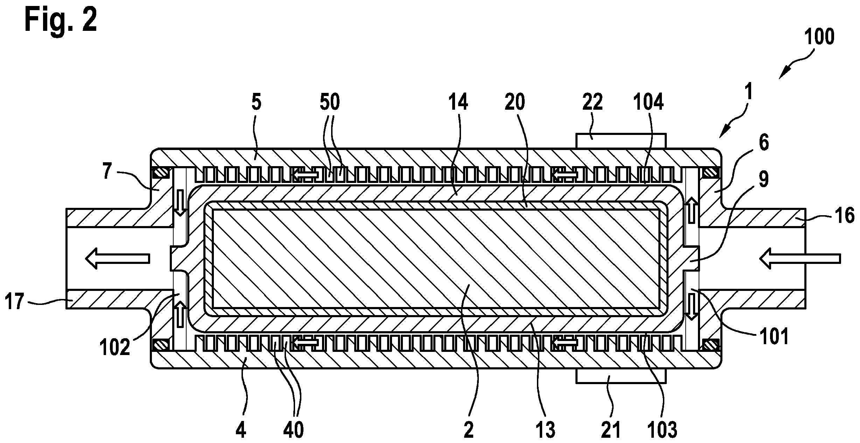

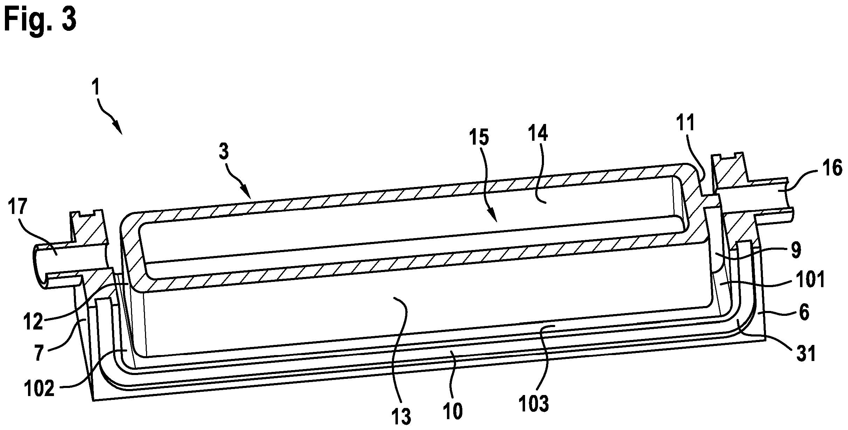

Wie insbesondere aus den Figuren 1 und 3 ersichtlich ist, umfasst die Kühleinrichtung 1 ein einteiliges Kühlgehäuse 3 mit fünf Gehäuseflächen. Das Kühlgehäuse 3 umfasst einen Boden 10, eine erste Stirnfläche 11, eine zweite Stirnfläche 12, eine erste Seitenfläche 13 und eine zweite Seitenfläche 14. Dadurch ergibt sich ein quaderförmiges Kühlgehäuse mit fünf Gehäuseflächen, welches oben offen ist. Das Kühlgehäuse 3 definiert einen zentralen Aufnahmeraum 15 zur Aufnahme eines Leistungsbauelements 2, wie in Figur 2 gezeigt.

Die Kühleinrichtung 1 umfasst ferner einen Zulauf 16 und einen Ablauf 17. Kühlmedium wird über den Zulauf zur Kühleinrichtung 1 zugeführt und über den Ablauf 17 abgeführt. Hierbei sind am äußeren Umfang des Kühlgehäuses 3 Kühlkanäle definiert. Genauer ist ein erster Kühlkanal 101 an der ersten Stirnfläche 11 ausgebildet und ein zweiter Kühlkanal 102 ist an der zweiten Stirnfläche 12 ausgebildet. Ein dritter Kühlkanal 103 ist an der ersten Seitenfläche 13 ausgebildet und ein vierter Kühlkanal 104 ist an der zweiten Seitenfläche 14 ausgebildet. Hier stehen die ersten und zweiten Kühlkanäle 101, 102 mit den dritten und vierten Kühlkanälen 103, 104 in Fluidverbindung, so dass das Kühlmedium ausgehend vom Zulauf über die Kühlkanäle zum Ablauf 17 strömen kann.

Wie insbesondere aus Figur 1 und 2 ersichtlich ist, sind die Kühlkanäle 101, 102, 103, 104 dieses Ausführungsbeispiels flächenartige Kühlkanäle. Die Kühlkanäle werden einerseits durch die Gehäuseflächen des Kühlgehäuses 3 und andererseits durch Kühlplatten, wie nachfolgend beschrieben, definiert. Hierbei umfasst die Kühleinrichtung 1 eine erste Kühlplatte 4, welche an der ersten Seitenfläche 13 angeordnet ist und den dritten Kühlkanal 103 definiert. Weiterhin ist eine zweite Kühlplatte 5 vorgesehen, welche an der zweiten Seitenflächen 14 angeordnet ist und den vierten Kühlkanal 103 definiert. Darüber hinaus ist eine dritte Kühlplatte 6 vorgesehen, welche an der ersten Stirnfläche 11 angeordnet ist und den ersten Kühlkanal 101 definiert. Weiterhin ist eine vierte Kühlplatte 7 vorgesehen, welche an der zweiten Stirnfläche 12 angeordnet ist und den zweiten Kühlkanal 102 definiert (vgl. Figur 2).

In diesem Ausführungsbeispiel sind die dritte Kühlplatte 6 und die vierte Kühlplatte 7 ebenfalls einstückig mit dem Kühlgehäuse 3 ausgebildet. Weiterhin sind auch der Zulauf 16 und der Ablauf 17 einstückig mit den Kühlplatten 6, 7 an der ersten und zweiten Stirnfläche 11, 12 ausgebildet.

Das einteilige Kühlgehäuse 3 dieses Ausführungsbeispiels ist aus einem Metall, vorzugsweise aus Aluminium, gefertigt. Wie insbesondere aus Figur 3 ersichtlich ist, sind dabei die dritte Kühlplatte 6 und die vierte Kühlplatte 7 über den Boden 10, welcher an den Stirnseiten über die Stirnflächen 11, 12 vorsteht, an das Kühlgehäuse angebunden. Ferner ist, wie in Figur 1 gezeigt, an dem dem Boden gegenüberliegenden Bereich eine rahmenartige Struktur zur Fixierung der dritten und vierten Kühlplatte 6, 7 und zur Aufnahme eines Deckels 8 vorgesehen.

Somit weist die Kühleinrichtung einen zentralen Aufnahmeraum 15 zur Aufnahme eines Leistungsbauelements 2 auf, welcher von vier Seiten mit einem Kühlmedium umströmbar ist. Durch die flächige Ausbildung der Kühlkanäle 101, 102, 103, 104 kann dabei ein ausreichender Wärmeabtransport sichergestellt werden. Die Durchströmung der Kühleinrichtung 1 mit Kühlmedium ist in Figur 2 durch die Pfeile angedeutet.

Wie weiter aus Figur 2 ersichtlich ist, sind an den zum Kühlgehäuse 3 gerichteten Seiten der ersten und zweiten Kühlplatte 4, 5 jeweils Kühlkörper 40 bzw. 50 vorgesehen, welche in Richtung zur ersten und zweiten Seitenfläche 13, 14 vorstehen. Die vorstehenden Kühlkörper 40, 50 sind vorzugsweise Zylinder und versetzt angeordnet, um eine turbulente Strömung zu erzeugen.

Wie weiter aus Figur 2 und 3 ersichtlich ist, ist an der ersten Stirnfläche 11 ferner noch ein Fluidteiler 9 ausgebildet, welcher vom Boden 10 vertikal vorsteht. Hierdurch wird das über den Zulauf 16 zugeführte Kühlmedium in zwei Ströme geteilt, um an den beiden Seitenflächen 13, 14 entlang zu strömen. Hierdurch wird vorzugsweise eine symmetrische Verteilung des Kühlmediums vorgesehen.

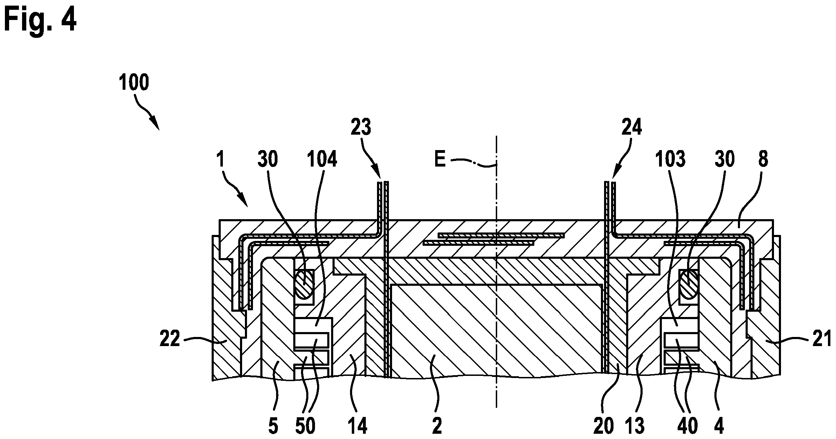

Weiterhin umfasst die Kühleinrichtung 1 den Deckel 8, welcher im Detail aus Figur 4 ersichtlich ist. Der Deckel 8 ist aus einem elektrisch isolierenden Material hergestellt, insbesondere Kunststoff. Der Deckel 8 überdeckt dabei insbesondere das Leistungsbauelement 2, welches im zentralen Aufnahmeraum 15 angeordnet ist. Wie aus Figur 4 ersichtlich ist, ist das Leistungsbauelement 2 dabei in einem Verguss 20 angeordnet, um einen elektrischen Kontakt zu den ersten und zweiten Seitenflächen 13, 14 zu vermeiden. Somit kann ein direkter Verguss des Leistungsbauelements 2 im Kühlgehäuse 3 erreicht werden.

Die Elektronikanordnung 100 umfasst ferner einen ersten Leistungsschalter 21 und einen zweiten Leistungsschalter 22. Wie in Figur 4 gezeigt, sind die beiden Leistungsschalter 21, 22 über elektrische Leitungen mit einem ersten und zweiten Busbar-Anschluss 23, 24 elektrisch verbunden. Ebenfalls ist das Leistungsbauelement 2 mit den Busbar-Anschlüssen 23, 24 elektrisch verbunden. Die beiden Leistungsschalter 21, 22 sind symmetrisch zu einer Mittelebene E der Elektronikanordnung 100 angeordnet. Hierdurch ist es auf einfache Weise möglich, dass zwischen den Busbar-Anschlüssen 23, 24 und den Leistungsschaltern 21, 22 gleiche elektrische Leitungslängen vorgesehen sind.

Die Elektronikanordnung 100 weist somit eine Kühleinrichtung 1 auf, welche vier flächige Kühlkanäle 101, 102, 103, 104 aufweist, die an den beiden Stirnseiten und an den beiden Seitenflächen der Kühleinrichtung angeordnet sind. Hierdurch kann das Leistungsbauelement 2 an vier Seiten gekühlt werden.

Das Leistungsbauelement 2 dieses Ausführungsbeispiels ist ein Kondensator, welcher in einem Steuergerät eines Fahrzeugs verwendet wird. Da der Kondensator unmittelbar im Steuergerät angeordnet werden kann, kann dem Steuergerät schnell eine notwendige elektrische Leistung durch den Kondensator bereitgestellt werden. Hierbei ist insbesondere die elektrische Verdrahtung symmetrisch vorgesehen und ebenfalls niederinduktiv, da durch die symmetrische Anordnung der Leistungsschalter 21, 22 sich elektrische Felder im Wesentlichen aufheben. Der Kondensator ist vorzugsweise ein Zwischenkreiskondensator und wird in einem Steuergerät zur Ansteuerung einer elektrischen Maschine eines Fahrzeugs verwendet. Hierbei kann eine sechspolige Maschinenansteuerung ausgeführt werden oder auch ein Doppelinverter für zwei dreipolige elektrische Maschinen.

Zur Abdichtung der Kühlkanäle sind, wie in Figur 4 gezeigt, zwischen den ersten und zweiten Seitenflächen 13, 14 und den ersten und zweiten Kühlplatten 4, 5 Dichtungen 30 vorgesehen. Die Dichtungen können in im Kühlgehäuse 3 vorgesehene Vertiefungen 31 eingelegt werden. Die Kühlplatten 4, 5 können an das Kühlgehäuse angeschweißt oder geklebt werden.

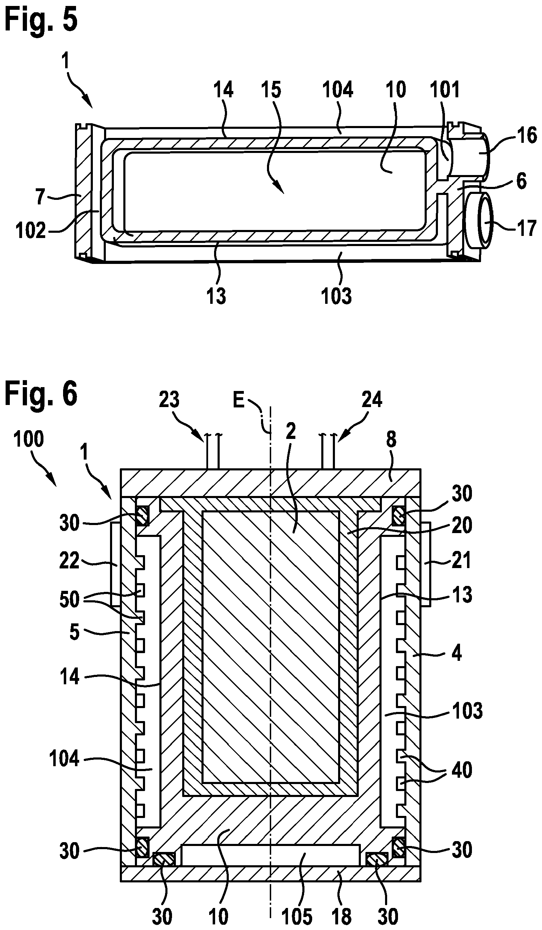

Die Figuren 5 und 6 zeigen eine Elektronikanordnung 100 mit einer Kühleinrichtung 1 gemäß einem zweiten Ausführungsbeispiel der Erfindung. Gleiche bzw. funktional gleiche Teile sind dabei mit den gleichen Bezugszeichen bezeichnet. Im Unterschied zum ersten Ausführungsbeispiel weist die Kühleinrichtung 1 des zweiten Ausführungsbeispiels zusätzlich noch einen fünften Kühlkanal 105 auf. Der fünfte Kühlkanal 105 ist zwischen dem Boden 10 und einer fünften Kühlplatte 18 definiert. Wie aus Figur 5 ersichtlich ist, sind dabei der Zulauf 16 und der Ablauf 17 an der gleichen Stirnseite der Kühleinrichtung 1, nämlich in diesem Ausführungsbeispiel der ersten Stirnfläche 11 angeordnet. Hierdurch wird der fünfte Kühlkanal 105 zur Rückströmung des Kühlmediums von der zweiten Stirnfläche 12 verwendet. Hierdurch kann insbesondere ein Fluidanschluss für das Fluidmedium an der Kühleinrichtung 1 einfacher ausgestaltet werden. Hierbei sei angemerkt, dass die Kühleinrichtung des zweiten Ausführungsbeispiels auch derart ausgebildet sein könnte, dass der fünfte Kühlkanal 105 nicht direkt mit dem Ablauf 17 verbunden ist, sondern direkt mit dem Zulauf 16 verbunden ist und der Ablauf 17 dann über den ersten Kühlkanal 101 mit den anderen Kühlkanälen fluidverbunden ist.

## Patentansprüche

1. Kühleinrichtung zur Kühlung eines Leistungsbauelements (2), umfassend:
- ein Kühlgehäuse (3) mit einem Boden (10), einer ersten Stirnfläche (11), einer zweiten Stirnfläche (12), einer ersten Seitenfläche (13) und einer zweiten Seitenfläche (14), welche einen Aufnahmeraum (15), welcher eingerichtet ist zur Aufnahme des Leistungsbauelements, definieren,
- einen Zulauf (16) zum Zuführen eines Kühlmediums,
- einen Ablauf (17) zum Abführen eines Kühlmediums,
- einen ersten Kühlkanal (101), einen zweiten Kühlkanal (102), einen dritten Kühlkanal (103) und einen vierten Kühlkanal (104), wobei der erste Kühlkanal (101) an der ersten Stirnfläche (11) angeordnet ist und der zweite Kühlkanal (102) an der zweiten Stirnfläche (12) angeordnet ist, und
- wobei der dritte Kühlkanal (103) an der ersten Seitenfläche (13) angeordnet ist und der vierte Kühlkanal (104) an der zweiten Seitenfläche (14) angeordnet ist,
- wobei der erste und zweite Kühlkanal (101, 102) jeweils mit dem dritten und vierten Kühlkanal (103, 104) in Fluidverbindung steht,
**gekennzeichnet durch**
- eine separate erste Kühlplatte (4) und eine separate zweite Kühlplatte (5), wobei die erste Kühlplatte (4) an der ersten Seitenfläche (13) angeordnet ist und die zweite Kühlplatte (5) an der zweiten Seitenfläche (14) angeordnet ist, um den dritten und vierten Kühlkanal (103, 104) zu begrenzen,
- eine dritte Kühlplatte (6), welche an der ersten Stirnfläche (11) angeordnet ist und eine vierte Kühlplatte (7), welche an der zweiten Stirnfläche (12) angeordnet ist, wobei die dritte Kühlplatte (6) den ersten Kühlkanal (101) begrenzt und die vierte Kühlplatte (7) den zweiten Kühlkanal (102) begrenzt, und
- einen Deckel (8), welcher das Kühlgehäuse (3) verschließt,
- wobei das Kühlgehäuse (3) einteilig ausgebildet ist.

2. Kühleinrichtung nach Anspruch 1, wobei die dritte Kühlplatte (6) und die vierte Kühlplatte (7) einstückig mit dem Kühlgehäuse (3) ausgebildet sind.

3. Kühleinrichtung nach Anspruch 2, wobei der Zulauf (16) und/oder der Ablauf (17) einstückig mit der dritten Kühlplatte (6) oder der vierten Kühlplatte (7) ausgebildet ist.

4. Kühleinrichtung nach einem der vorhergehenden Ansprüche, ferner umfassend einen fünften Kühlkanal (105), welcher am Boden (10) des Kühlgehäuses (3) ausgebildet ist und mittels einer fünften Kühlplatte (18) begrenzt ist.

5. Kühleinrichtung nach Anspruch 4, wobei der fünfte Kühlkanal (105) mit dem ersten Kühlkanal (101) und/oder dem zweiten Kühlkanal (102) in Fluidverbindung steht.

6. Kühleinrichtung nach einem der vorhergehenden Ansprüche, wobei der Zulauf (16) und der Ablauf (17) an der dritten Kühlplatte (6) angeordnet sind oder wobei der Zulauf (16) an der dritten Kühlplatte (6) angeordnet ist und der Ablauf (17) an der vierten Kühlplatte (7) angeordnet ist.

7. Kühleinrichtung nach einem der vorhergehenden Ansprüche, wobei im ersten Kühlkanal (101) ein Fluidteiler (9) angeordnet ist.

8. Kühleinrichtung nach einem der vorhergehenden Ansprüche, wobei das Kühlgehäuse (3) eine Quaderform aufweist.

9. Elektronikanordnung, umfassend eine Kühleinrichtung (1) nach einem der vorhergehenden Ansprüche und ein in der Kühleinrichtung angeordnetes Leistungsbauelement (2).

10. Elektronikanordnung nach Anspruch 9, wobei das Leistungsbauelement (2) im Kühlgehäuse (3) der Kühleinrichtung (1) mittels eines Vergusses (20) vergossen ist.

11. Elektronikanordnung nach Anspruch 9 oder 10, ferner umfassend einen ersten Leistungsschalter (21) und einen zweiten Leistungsschalter (22), wobei der erste Leistungsschalter (21) an der ersten Kühlplatte (4) angeordnet ist und der zweite Leistungsschalter (22) an der zweiten Kühlplatte (5) angeordnet ist.

12. Elektronikanordnung nach Anspruch 11, wobei der erste Leitungsschalter (21) und der zweite Leitungsschalter (22) symmetrisch zu einer Längsebene (E) der Elektronikanordnung angeordnet sind.

13. Elektronikanordnung nach einem der Ansprüche 9 bis 12, ferner umfassend wenigstens einen Busbar-Anschluss (23, 24), wobei der Busbar-Anschluss (23, 24) im Deckel (8) der Kühleinrichtung (1) angeordnet ist.

14. Elektronikanordnung nach einem der Ansprüche 9 bis 13, wobei das Leistungsbauelement (2) ein Kondensator, insbesondere ein Zwischenkreiskondensator ist.

15. Steuergerät eines Fahrzeugs, insbesondere zur Steuerung einer elektrischen Maschine, umfassend eine Elektronikanordnung nach einem der Ansprüche 9 bis 14.

## Claims

1. Cooling device for cooling a power component (2), comprising:
- a cooling housing (3) having a base (10), a first end face (11), a second end face (12), a first lateral face (13) and a second lateral face (14), which define a receiving area (15) which is designed for the accommodation of the power component,
- an inlet (16) for the admission of a cooling medium,
- an outlet (17) for discharging a cooling medium,
- a first cooling channel (101), a second cooling channel (102), a third cooling channel (103) and a fourth cooling channel (104), wherein the first cooling channel (101) is arranged on the first end face (11) and the second cooling channel (102) is arranged on the second end face (12), and
- wherein the third cooling channel (103) is arranged on the first lateral face (13) and the fourth cooling channel (104) is arranged on the second lateral face (14),
- wherein the first and second cooling channels (101, 102) are respectively fluidically connected to the third and fourth cooling channels (103, 104),
**characterized by**
- a separate first cooling plate (4) and a separate second cooling plate (5), wherein the first cooling plate (4) is arranged on the first lateral face (13) and the second cooling plate (5) is arranged on the second lateral face (14), in order to delimit the third and fourth cooling channels (103, 104),
- a third cooling plate (6), which is arranged on the first end face (11), and a fourth cooling plate (7), which is arranged on the second end face (12), wherein the third cooling plate (6) delimits the first cooling channel (101) and the fourth cooling plate (7) delimits the second cooling channel (102), and
- a cover (8), which closes the cooling housing (3),
- wherein the cooling housing (3) is configured in one piece.

2. Cooling device according to Claim 1, wherein the third cooling plate (6) and the fourth cooling plate (7) are configured integrally with the cooling housing (3).

3. Cooling device according to Claim 2, wherein the inlet (16) and/or the outlet (17) is configured integrally with the third cooling plate (6) or the fourth cooling plate (7).

4. Cooling device according to one of the preceding claims, further comprising a fifth cooling channel (105), which is configured on the base (10) of the cooling housing (3) and is delimited by means of a fifth cooling plate (18).

5. Cooling device according to Claim 4, wherein the fifth cooling channel (105) is fluidically connected to the first cooling channel (101) and/or to the second cooling channel (102).

6. Cooling device according to one of the preceding claims, wherein the inlet (16) and the outlet (17) are arranged on the third cooling plate (6), or wherein the inlet (16) is arranged on the third cooling plate (6) and the outlet (17) is arranged on the fourth cooling plate (7).

7. Cooling device according to one of the preceding claims, wherein a fluid divider (9) is arranged in the first cooling channel (101).

8. Cooling device according to one of the preceding claims, wherein the cooling housing (3) assumes a cuboid shape.

9. Electronic assembly, comprising a cooling device (1) according to one of the preceding claims, and a power component (2) arranged in the cooling device .

10. Electronic assembly according to Claim 9, wherein the power component (2) is embedded in the cooling housing (3) of the cooling device (1) by means of a casting compound (20).

11. Electronic assembly according to Claim 9 or 10, further comprising a first power circuit-breaker (21) and a second power circuit-breaker (22), wherein the first power circuit-breaker (21) is arranged on the first cooling plate (4), and the second power circuit-breaker (22) is arranged on the second cooling plate (5).

12. Electronic assembly according to Claim 11, wherein the first power circuit-breaker (21) and the second power circuit-breaker (22) are arranged symmetrically to a longitudinal plane (E) of the electronic assembly.

13. Electronic assembly according to one of Claims 9 to 12, further comprising at least one busbar terminal (23, 24), wherein the busbar terminal (23, 24) is arranged in the cover (8) of the cooling device (1).

14. Electronic assembly according to one of Claims 9 to 13, wherein the power component (2) is a capacitor, particularly an intermediate circuit capacitor.

15. Control device of a vehicle, particularly for controlling an electrical machine, comprising an electronic assembly according to one of Claims 9 to 14.

## Revendications

1. Dispositif de refroidissement pour refroidir un composant de puissance (2), comprenant :
- une enceinte de refroidissement (3) ayant un fond (10), une première surface frontale (11), une deuxième surface frontale (12), une première surface latérale (13) et une deuxième surface latérale (14), qui définissent un espace de réception (15) qui est adapté pour recevoir le composant de puissance,
- une alimentation (16) pour amener un fluide de refroidissement,
- une évacuation (17) pour évacuer un fluide de refroidissement,
- un premier canal de refroidissement (101), un deuxième canal de refroidissement (102), un troisième canal de refroidissement (103) et un quatrième canal de refroidissement (104), le premier canal de refroidissement (101) étant agencé sur la première surface frontale (11) et le deuxième canal de refroidissement (102) étant agencé sur la deuxième surface frontale (12), et
- le troisième canal de refroidissement (103) étant agencé sur la première surface latérale (13) et le quatrième canal de refroidissement (104) étant agencé sur la deuxième surface latérale (14),
- le premier et le deuxième canal de refroidissement (101, 102) étant respectivement en communication fluidique avec le troisième et le quatrième canal de refroidissement (103, 104),
**caractérisé par**
- une première plaque de refroidissement séparée (4) et une deuxième plaque de refroidissement séparée (5), la première plaque de refroidissement (4) étant agencée sur la première surface latérale (13) et la deuxième plaque de refroidissement (5) étant agencée sur la deuxième surface latérale (14) afin de délimiter le troisième et le quatrième canal de refroidissement (103, 104),
- une troisième plaque de refroidissement (6) qui est agencée sur la première surface frontale (11) et une quatrième plaque de refroidissement (7) qui est agencée sur la deuxième surface frontale (12), la troisième plaque de refroidissement (6) délimitant le premier canal de refroidissement (101) et la quatrième plaque de refroidissement (7) délimitant le deuxième canal de refroidissement (102), et
- un couvercle (8) qui ferme l'enceinte de refroidissement (3),
- l'enceinte de refroidissement (3) étant réalisée d'un seul tenant.

2. Dispositif de refroidissement selon la revendication 1, la troisième plaque de refroidissement (6) et la quatrième plaque de refroidissement (7) étant réalisées d'un seul tenant avec l'enceinte de refroidissement (3).

3. Dispositif de refroidissement selon la revendication 2, l'alimentation (16) et/ou l'évacuation (17) étant réalisées d'un seul tenant avec la troisième plaque de refroidissement (6) ou la quatrième plaque de refroidissement (7).

4. Dispositif de refroidissement selon l'une quelconque des revendications précédentes, comprenant en outre un cinquième canal de refroidissement (105) qui est réalisé sur le fond (10) de l'enceinte de refroidissement (3) et qui est délimité au moyen d'une cinquième plaque de refroidissement (18).

5. Dispositif de refroidissement selon la revendication 4, le cinquième canal de refroidissement (105) étant en communication fluidique avec le premier canal de refroidissement (101) et/ou le deuxième canal de refroidissement (102).

6. Dispositif de refroidissement selon l'une quelconque des revendications précédentes, l'alimentation (16) et l'évacuation (17) étant agencées sur la troisième plaque de refroidissement (6) ou l'alimentation (16) étant agencée sur la troisième plaque de refroidissement (6) et l'évacuation (17) étant agencée sur la quatrième plaque de refroidissement (7).

7. Dispositif de refroidissement selon l'une quelconque des revendications précédentes, un diviseur de fluide (9) étant agencé dans le premier canal de refroidissement (101).

8. Dispositif de refroidissement selon l'une quelconque des revendications précédentes, l'enceinte de refroidissement (3) présentant une forme parallélépipédique.

9. Agencement électronique, comprenant un dispositif de refroidissement (1) selon l'une quelconque des revendications précédentes et un composant de puissance (2) agencé dans le dispositif de refroidissement.

10. Agencement électronique selon la revendication 9, le composant de puissance (2) étant enrobé dans l'enceinte de refroidissement (3) du dispositif de refroidissement (1) au moyen d'un enrobage (20).

11. Agencement électronique selon la revendication 9 ou 10, comprenant en outre un premier commutateur de puissance (21) et un deuxième commutateur de puissance (22), le premier commutateur de puissance (21) étant agencé sur la première plaque de refroidissement (4) et le deuxième commutateur de puissance (22) étant agencé sur la deuxième plaque de refroidissement (5).

12. Agencement électronique selon la revendication 11, le premier commutateur de puissance (21) et le deuxième commutateur de puissance (22) étant agencés symétriquement par rapport à un plan longitudinal (E) de l'agencement électronique.

13. Agencement électronique selon l'une quelconque des revendications 9 à 12, comprenant en outre au moins une connexion de barre omnibus (23, 24), la connexion de barre omnibus (23, 24) étant agencée dans le couvercle (8) du dispositif de refroidissement (1).

14. Agencement électronique selon l'une quelconque des revendications 9 à 13, le composant de puissance (2) étant un condensateur, en particulier un condensateur de circuit intermédiaire.

15. Appareil de commande d'un véhicule, en particulier pour commander une machine électrique, comprenant un agencement électronique selon l'une quelconque des revendications 9 à 14.
